# EUROPEAN PATENT APPLICATION

(11) **EP 4 632 878 A2**
(43) Date of publication of application: **15.10.2025**
(21) Application number: 25164540.4
(22) Date of filing: 18.03.2025
(51) Int. Cl.: H01M 10/625, B60H 1/00, B60L 58/24, H01M 10/6556, H01M 10/6568, H01M 10/663

(54) **THERMAL MANAGEMENT SYSTEM**

(30) Priority: 21.03.2024 JP 2024044684
(71) Applicant: TOYOTA JIDOSHA KABUSHIKI KAISHA, Toyota-shi, Aichi-ken, 471-8571 (JP)
(72) Inventor: MIYOSHI, Yuji, Aichi-ken, 471-8571 (JP); KAWABE, Takayuki, Aichi-ken, 471-8571 (JP); IMAI, Sohichi, Aichi-ken, 471-8571 (JP)
(74) Representative: D Young & Co LLP

(57) **Abstract**

A thermal management system (1) includes a first flow path (130a) through which a heat medium flows, a second flow path (170a) through which the heat medium flows, a reserve tank (175) provided in the second flow path (170a), a water pump (131) that circulates the heat medium, and a switching device (180). The thermal management system (1) executes an air removal process for the second flow path (170a) and the first flow path (130a) by connecting the second flow path (170a) and the first flow path (130a) with the switching device (180) and driving the water pump (131) in a case where a temperature of a heat-exchanged device (173) is lower than a specified temperature in a state where the second flow path (170a) and the first flow path (130a) are disconnected.

## Description

### BACKGROUND OF THE INVENTION

### 1. Field of the Invention

The present disclosure relates to a thermal management system.

### 2. Description of Related Art

Japanese Unexamined Patent Application Publication No. 2023-063735 (JP 2023-063735 A) discloses a temperature control system including a coolant circuit in which a path to which a PCU is connected, a path to which a battery is connected, a reserve tank, and a five-way valve that switches a flow path of a coolant are provided.

### SUMMARY OF THE INVENTION

Here, although not described in JP 2023-063735 A, there are cases where a circuit in which the path to which the PCU is connected (first flow path) or the path to which the battery is connected (second flow path) and the reserve tank are not connected is temporarily formed by controlling a state of the five-way valve. In this case, there is a concern that air bubbles are mixed (remain) in the path that is not connected to the reserve tank.

The present disclosure provides a thermal management system capable of suppressing air bubbles from being mixed (remaining) in a first flow path and a second flow path by using a reserve tank.

A first aspect of the present disclosure relates to a thermal management system provided in a chargeable electric device. The thermal management system includes a first flow path through which a heat medium flows, a second flow path through which the heat medium flows and in which a reserve tank is provided, a heat-exchanged device, a switching device, a pump, and a control device. The heat-exchanged device is configured to exchange heat with the heat medium flowing through one of the first flow path and the second flow path. The switching device is configured to switch a connection state between the first flow path and the second flow path. The pump is configured to circulate the heat medium in each of the first flow path and the second flow path in a state where the first flow path and the second flow path are connected. The control device is configured to control the switching device and the pump. The control device is configured to, in a case where a temperature of the heat-exchanged device is lower than a first temperature in a state where the first flow path and the second flow path are disconnected, connect the first flow path and the second flow path by the switching device and to execute an air removal process for the first flow path and the second flow path by driving the pump.

In the thermal management system according to the first aspect of the present disclosure, as described above, the air removal process is executed for the first flow path and the second flow path in a case where the temperature of the heat-exchanged device is lower than the first temperature in a state where the first flow path and the second flow path are disconnected. As a result, the air removal is performed on each of the first flow path and the second flow path in a case where the temperature of the heat-exchanged device is lower than the first temperature. As a result, it is possible to suppress air bubbles from being mixed in (remaining) in each of the first flow path and the second flow path by using the reserve tank.

Additionally, since the air removal process is executed in a case where the temperature of the heat-exchanged device is lower than the first temperature, it is possible to suppress the air removal process from being performed without cooling the heat-exchanged device when the heat-exchanged device needs to be cooled. As a result, it is possible to suppress the temperature of the heat-exchanged device from being excessively high. Furthermore, the heat medium that is heated by heat of the heat-exchanged device can be suppressed from being circulated by the air removal process.

In the thermal management system according to the first aspect, the control device may be configured to end the air removal process in a case where the air removal process has continued for a first time or longer. With the configuration as described above, it is possible to prevent the air removal process from being continued for the first time or longer. As a result, a time needed for executing one air removal process can be relatively shortened.

In the thermal management system according to the first aspect, the heat-exchanged device may include a first power storage device. The thermal management system may further include a first drive device configured to exchange heat with the heat medium flowing through the other of the first flow path and the second flow path and to generate a drive force. With the configuration as described above, each of the first power storage device and the first drive device can be efficiently cooled by the heat medium by suppressing air bubbles from being mixed in (remaining) in each of the first flow path and the second flow path.

In this case, the control device may be configured to stop the air removal process in a case where a temperature of the first power storage device is equal to or higher than the first temperature during the execution of the air removal process. With the configuration as described above, the circulation of the heat medium heated by heat of the first power storage device can be suppressed by the air removal process. In addition, in a case where the temperature of the first power storage device becomes equal to or higher than the first temperature, the air removal process can be stopped and other control (for example, cooling of the first power storage device) can be performed.

The thermal management system including the first power storage device may further include a bypass path that bypasses at least a portion of the one of the first flow path and the second flow path at which heat exchange between the first power storage device and the heat medium occurs. The control device nay be configured to, during the execution of the air removal process, cause the heat medium to flow through the bypass path without causing the heat medium to flow through the portion in a case where a temperature of the heat medium flowing through the other of the first flow path and the second flow path is equal to or higher than a second temperature. With the configuration as described above, the air removal process can be performed while suppressing the first power storage device from being heated by the heat medium flowing through the other of the first flow path and the second flow path.

In the thermal management system according to the first aspect, the control device may not execute the air removal process in a case where an accumulated time during which the pump is driven in the state where the first flow path and the second flow path are connected exceeds a second time. With the configuration as described above, it is possible to suppress the air removal process from being excessively performed on the electric device.

In this case, the accumulated time may be a total value of a first accumulated time during which the air removal process is executed and a second accumulated time during which the pump is driven in the state where the first flow path and the second flow path are connected at a time other than when the air removal process is being executed. With the configuration as described above, unlike the case where solely the first accumulated time is considered as the accumulated time, control for restricting the execution of the air removal process can be performed based on a time during which the air removal is actually performed on the first flow path and the second flow path.

In the thermal management system according to the first aspect, the control device may be configured to, in a case where the heat medium flowing through the electric device in a state where the air removal process is not being executed is exchanged, set the thermal management system to a state in which the air removal process is executable. Here, when the heat medium is exchanged, the air bubbles are likely to be mixed. Therefore, with the configuration as described above, the air bubbles mixed due to the exchange of the heat medium can be removed by the air removal process.

In the thermal management system according to the first aspect, the switching device may include a five-way valve or an eight-way valve. With the configuration as described above, the connection state between the first flow path and the second flow path can be easily switched by the five-way valve or the eight-way valve.

The thermal management system according to the first aspect may further include: a radiator; and a second drive device configured to generate a drive force. The heat-exchanged device may include a second power storage device. The radiator may be provided in the second flow path. At least one of the second power storage device and the second drive device may exchange heat with the heat medium flowing through the first flow path. With the configuration as described above, it is possible to perform the air removal on the first flow path and the second flow path while cooling at least one of the second power storage device and the second drive device by using the heat medium cooled by the radiator.

According to the present disclosure, it is possible to suppress air bubbles from being mixed (remaining) in the first flow path and the second flow path by using the reserve tank.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram showing a configuration of an electrified vehicle equipped with a thermal management system according to an embodiment;
FIG. 2 is a diagram showing an example of a configuration of a thermal management system according to an embodiment;
FIG. 3 is a diagram showing an example of a configuration of a thermal management circuit according to an embodiment;
FIG. 4 is a diagram showing a first communication pattern of the thermal management circuit according to the embodiment;
FIG. 5 is a diagram showing a second communication pattern of the thermal management circuit according to the embodiment;
FIG. 6 is a diagram showing a third communication pattern of the thermal management circuit according to the embodiment;
FIG. 7 is a first diagram showing a control flow in the thermal management system according to the embodiment;
FIG. 8 is a second diagram showing the control flow in the thermal management system according to the embodiment;
FIG. 9 is a third diagram showing the control flow in the thermal management system according to the embodiment;
FIG. 10 is a fourth diagram showing the control flow in the thermal management system according to the embodiment;
FIG. 11 is a diagram showing an example of a configuration of a thermal management system according to a first modification example of the embodiment;
FIG. 12 is a diagram showing a first communication pattern in the first modification example;
FIG. 13 is a diagram showing a second communication pattern in the first modification example;
FIG. 14 is a diagram showing a first modification example of the second communication pattern in the first modification example;
FIG. 15 is a diagram showing a second modification example of the second communication pattern in the first modification example;
FIG. 16 is a diagram showing a first communication pattern of a thermal management system according to a second modification example of the embodiment;
FIG. 17 is a diagram showing a second communication pattern of the second modification example;
FIG. 18 is a diagram showing a first modification example of the second communication pattern in the second modification example; and
FIG. 19 is a diagram showing a second modification example of the second communication pattern in the second modification example.

### DETAILED DESCRIPTION OF EMBODIMENTS

Hereinafter, an embodiment of the present disclosure will be described in detail with reference to the drawings. Note that, in the drawings, the same or equivalent parts are denoted by the same reference numerals, and description thereof will not be repeated.

Hereinafter, a configuration in which a thermal management system according to the present disclosure is mounted on a vehicle will be described as an example. The vehicle is preferably a vehicle equipped with a battery for traveling. The vehicle is, for example, a battery electric vehicle (BEV), a hybrid electric vehicle (HEV), a plug-in hybrid electric vehicle (PHEV), or a fuel cell electric vehicle (FCEV). Note that an application of the thermal management system according to the present disclosure is not limited to vehicles.

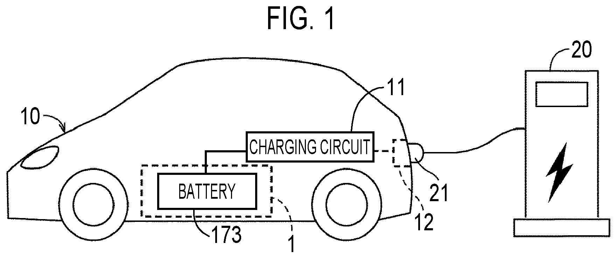

FIG. 1 is a diagram showing an electrified vehicle 10 equipped with a thermal management system 1 according to an embodiment of the present disclosure. The electrified vehicle 10 is chargeable. Specifically, the electrified vehicle 10 includes a battery 173, a charging circuit 11, and an inlet 12. The electrified vehicle 10 is an example of an "electric device" of the present disclosure. The battery 173 is an example of a "first power storage device" and a "heat-exchanged device".

The battery 173 stores electric power for driving the electrified vehicle 10. For example, by connecting a charging connector 21 of an EVSE 20 to the inlet 12, electric power is supplied from the EVSE 20 to the battery 173. The electric power input to the inlet 12 is supplied to the battery 173 through the charging circuit 11. The charging circuit 11 may include an SPU 132, which will be described later.

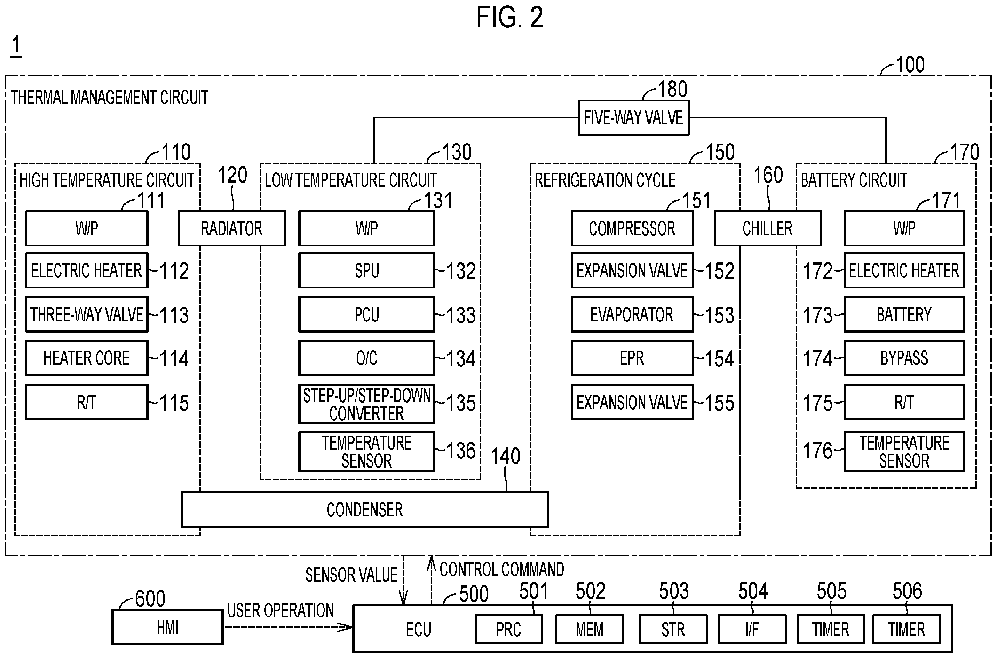

FIG. 2 is a diagram showing an example of an overall configuration of the thermal management system 1. The thermal management system 1 includes a thermal management circuit 100, an electronic control unit (ECU) 500, and a human machine interface (HMI) 600.

The thermal management circuit 100 is configured to allow a heat medium to flow. The thermal management circuit 100 includes a high temperature circuit 110, a radiator 120, a low temperature circuit 130, a condenser 140, a refrigeration cycle 150, a chiller 160, a battery circuit 170, and a five-way valve 180. The five-way valve 180 is an example of a "switching device" of the present disclosure.

The high temperature circuit 110 includes a water pump (W/P) 111, an electric heater 112, a three-way valve 113, a heater core 114, and a reserve tank (R/T) 115. The radiator 120 is connected to (that is, shared with) both the high temperature circuit 110 and the low temperature circuit 130.

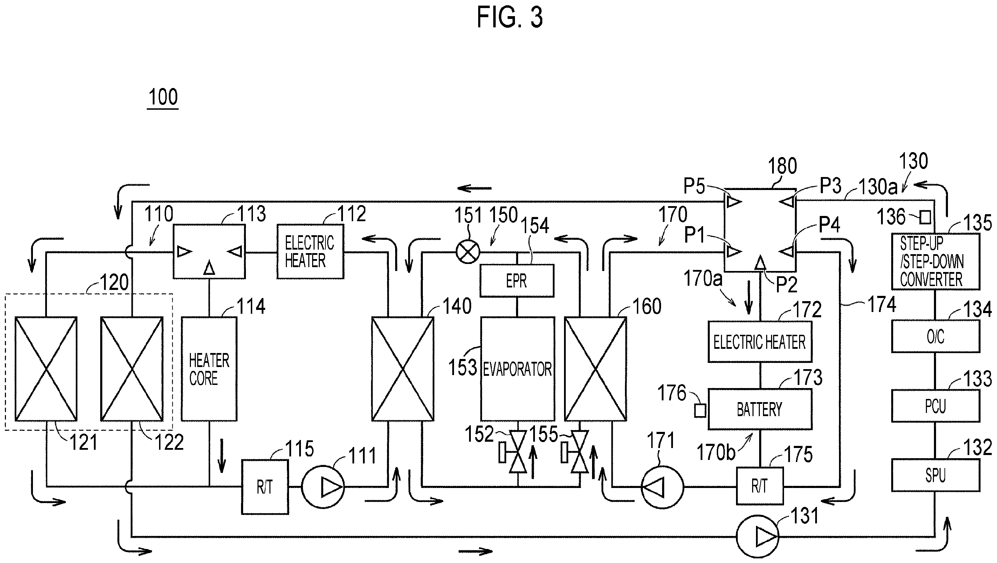

The radiator 120 includes a high temperature (HT) radiator 121 and a low temperature (LT) radiator 122 (see FIG. 3 for both).

The low temperature circuit 130 includes, for example, a water pump 131, a smart power unit (SPU) 132, a power control unit (PCU) 133, an oil cooler (O/C) 134, a step-up/step-down converter 135, and a temperature sensor 136. The water pump 131 is an example of a "pump" of the present disclosure. Each of the PCU 133 and the oil cooler 134 is a device that can generate a drive force to be supplied to the electrified vehicle 10. Each of the PCU 133 and the oil cooler 134 is an example of a "first drive device" of the present disclosure.

The condenser 140 is connected to both the high temperature circuit 110 and the refrigeration cycle 150. The refrigeration cycle 150 includes a compressor 151, an expansion valve 152, an evaporator 153, an evaporative pressure regulator (EPR) 154, and an expansion valve 155. The chiller 160 is connected to both the refrigeration cycle 150 and the battery circuit 170.

The battery circuit 170 includes, for example, a water pump 171, an electric heater 172, a battery 173, a bypass path 174, a reserve tank 175, and a temperature sensor 176. The five-way valve 180 is connected to the low temperature circuit 130 and the battery circuit 170. The configuration of the thermal management circuit 100 will be described in detail with reference to FIG. 3. The water pump 171 is an example of the "pump" of the present disclosure.

The ECU 500 controls the thermal management circuit 100. The ECU 500 includes a processor 501, a memory 502, a storage 503, an interface 504, a timer 505, and a timer 506.

The processor 501 is, for example, a central processing unit (CPU) or a micro processing unit (MPU). The memory 502 is, for example, a random access memory (RAM). The storage 503 is a rewritable non-volatile memory, such as a hard disk drive (HDD), a solid state drive (SSD), or a flash memory. The storage 503 stores a system program including an operating system (OS) and a control program including a computer-readable code needed for control calculation. The processor 501 implements various processes by reading out the system program and the control program and deploying the programs in the memory 502 to execute the programs. The interface 504 controls communication between the ECU 500 and components of the thermal management circuit 100. Each of the timers 505, 506 measures an elapsed time after a predetermined process is executed. Details of each function of the timers 505, 506 will be described later.

The ECU 500 generates a control command based on sensor values (for example, temperatures at various locations) acquired from various sensors (not shown) included in the thermal management circuit 100, a user operation received by the HMI 600, and the like, and outputs the generated control command to the thermal management circuit 100. The ECU 500 may be divided into a plurality of ECUs according to functions. Although FIG. 2 shows an example in which the ECU 500 includes one processor 501, the ECU 500 may include a plurality of processors. The same applies to the memory 502 and the storage 503.

In the present specification, the "processor" is not limited to a processor in a narrow sense that executes processing in a stored program method. The "processor" may include a hardwired circuit, such as an application specific integrated circuit (ASIC) or a field-programmable gate array (FPGA). Therefore, the term "processor" can be interpreted as a processing circuitry in which processing is defined in advance by computer-readable code and/or a hardwired circuit.

The HMI 600 includes a display with a touch panel, an operation panel, a console, and the like. The HMI 600 receives a user operation for controlling the thermal management system 1. The HMI 600 outputs a signal indicating the user operation to the ECU 500.

### Configuration of Thermal Management Circuit

FIG. 3 is a diagram showing an example of the configuration of the thermal management circuit 100 in the present embodiment. The heat medium (usually hot water) circulating in the high temperature circuit 110 flows through one or both of a first path of the water pump 111 - the condenser 140 - the electric heater 112 - the three-way valve 113 - the heater core 114 - the reserve tank 115 - the water pump 111, and a second path of the water pump 111 - the condenser 140 - the electric heater 112 - the three-way valve 113 - the high temperature radiator 121 - the reserve tank 115 - the water pump 111.

The heat medium (coolant) circulating in the low temperature circuit 130 flows through a path of the water pump 131 - the SPU 132 - the PCU 133 - the oil cooler 134 - the step-up/step-down converter 135 - the five-way valve 180 - the low temperature radiator 122 - the water pump 131. This path includes a flow path 130a of the water pump 131, the SPU 132 - the PCU 133 - the oil cooler 134 - the step-up/step-down converter 135 - the five-way valve 180. The flow path 130a is an example of a "first flow path" of the present disclosure.

The water pump 131 circulates the heat medium in the low temperature circuit 130 according to the control command from the ECU 500 (see FIG. 2). The SPU 132 controls charging and discharging of the battery 173 according to the control command from the ECU 500. The PCU 133 converts direct current power supplied from the battery 173 into alternating current power according to the control command from the ECU 500, and supplies the alternating current power to a motor (not shown) built in a transaxle. The oil cooler 134 circulates lubricating oil for the motor by using an electric oil pump (EOP) (not shown). The temperature sensor 136 detects a temperature of the heat medium flowing through the flow path 130a (for example, an upstream side of the step-up/step-down converter 135). The SPU 132, the PCU 133, the oil cooler 134, and the step-up/step-down converter 135 are cooled by the heat medium that circulates in the low temperature circuit 130. The five-way valve 180 switches the path of the heat medium in the low temperature circuit 130 and the battery circuit 170 according to the control command from the ECU 500. The low temperature radiator 122 is disposed near the high temperature radiator 121 and exchanges heat with the high temperature radiator 121.

The heat medium (vapor-phase refrigerant or liquid-phase refrigerant) circulating in the refrigeration cycle 150 flows through one or both of a first path and a second path described below. The first path is a path of the compressor 151 - the condenser 140 - the expansion valve 152 - the evaporator 153 - the EPR 154 - the compressor 151. The second path is a path of the compressor 151 - the condenser 140 - the expansion valve 155 - the chiller 160 - the compressor 151.

The heat medium (coolant) circulating in the battery circuit 170 flows through one or both of a first path of the water pump 171 - the chiller 160 - the five-way valve 180 - the electric heater 172 - the battery 173 - the reserve tank 175 - the water pump 171 and a second path of the water pump 171 - the chiller 160 - the five-way valve 180 - the bypass path 174 - the reserve tank 175 - the water pump 171. The reserve tank 175 is provided at a portion where the first path and the bypass path 174 join together. The first path includes a flow path 170a of the five-way valve 180 - the electric heater 172 - the battery 173 - the reserve tank 175 - the water pump 171. A disposition position of the reserve tank 175 is not limited to the example described above. For example, the reserve tank 175 may be disposed between the five-way valve 180 and the battery 173. The flow path 170a is an example of a "second flow path" of the present disclosure.

The water pump 171 circulates the heat medium in the battery circuit 170 according to the control command from the ECU 500. The chiller 160 cools the heat medium circulating in the battery circuit 170 by heat exchange between the heat medium circulating in the refrigeration cycle 150 and the heat medium circulating in the battery circuit 170. The electric heater 172 heats the heat medium according to the control command from the ECU 500. The battery 173 supplies electric power for traveling to the motor built in the transaxle. The battery 173 can be heated by using the electric heater 172 or can be cooled by using the chiller 160. The bypass path 174 bypasses at least a portion 170b of the flow path 170a at which heat is exchanged between the battery 173 and the heat medium. The bypass path 174 is provided such that the heat medium bypasses the electric heater 172 (a portion (not numbered) of the flow path 170a that exchanges heat with the electric heater 172) and the battery 173 (the portion 170b). In a case where the heat medium flows through the bypass path 174, a change in the temperature of the heat medium due to heat absorption and heat dissipation between the heat medium and the battery 173 can be suppressed. The reserve tank 175 stores a portion of the heat medium in the battery circuit 170 to maintain a pressure and amount of the heat medium in the battery circuit 170. The temperature sensor 176 detects a temperature of the battery 173.

The five-way valve 180 is provided with five ports P1 to P5. The port P1 is an inlet port into which the heat medium flows from the chiller 160. The port P2 is an outlet port through which the heat medium flows out toward the electric heater 172 and the battery 173 (the portion 170b) of the battery circuit 170. The port P3 is an inlet port into which the heat medium flows from the SPU 132, the PCU 133, the oil cooler 134, and the step-up/step-down converter 135 of the low temperature circuit 130. The port P4 is an outlet port through which the heat medium flows out toward the bypass path 174 of the battery circuit 170. The port P5 is an outlet port through which the heat medium flows out toward the low temperature radiator 122.

### Communication Pattern

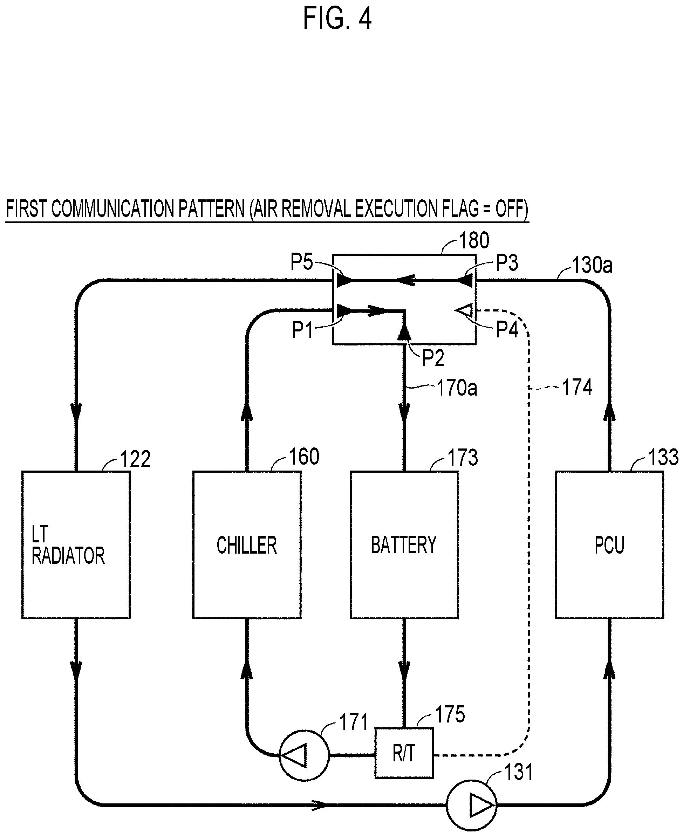

FIG. 4 is a diagram showing an example of a first communication pattern by the five-way valve 180. As shown in FIG. 4, in the first communication pattern, in the five-way valve 180, a path in which the port P1 and the port P2 communicate with each other, and a path in which the port P3 and the port P5 communicate with each other are formed. The two paths are independent of each other. Another path connecting the two paths is not formed. In this case, the low temperature circuit 130 (flow path 130a) and the battery circuit 170 (flow path 170a) are connected in parallel completely independently. The first communication pattern is a circuit pattern formed when an "air removal execution flag", which will be described later, is in an OFF state.

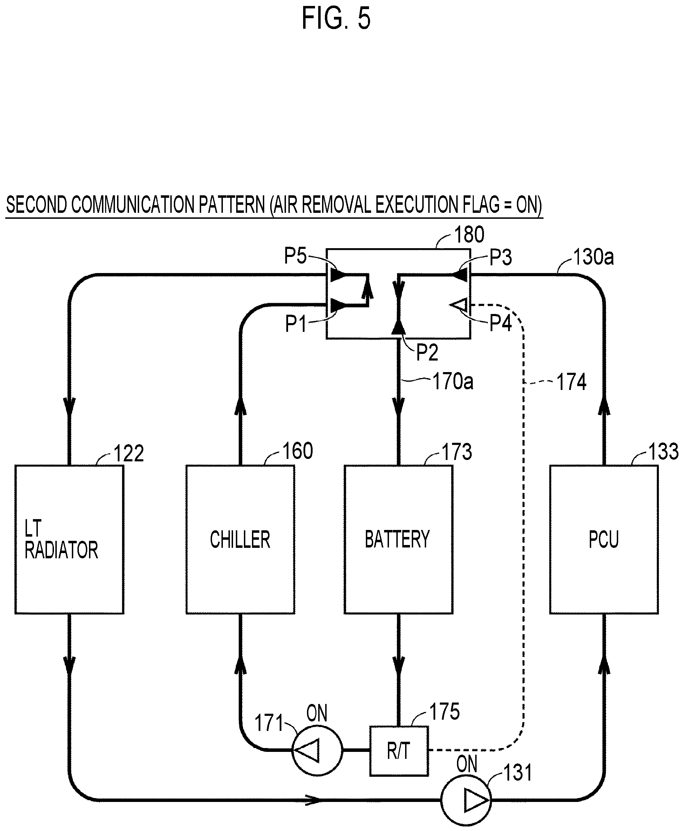

FIG. 5 is a diagram showing an example of a second communication pattern by the five-way valve 180. As shown in FIG. 5, in the second communication pattern, in the five-way valve 180, a path in which the port P1 and the port P5 communicate with each other, and a path in which the port P3 and the port P2 communicate with each other are formed. In this case, the low temperature circuit 130 (flow path 130a) and the battery circuit 170 (flow path 170a) are connected in series. As a result, the reserve tank 175, the water pump 171, and the water pump 131 are connected in series. In this state, at least one of the water pump 171 and the water pump 131 is driven, whereby air removal is performed on each of the flow path 170a and the flow path 130a by the reserve tank 175. The second communication pattern is a circuit pattern formed when the "air removal execution flag", which will be described later, is in an ON state and a predetermined condition, which will be described later, is satisfied. In the present embodiment, in the second communication pattern, each of the water pump 171 and the water pump 131 is driven. Note that solely one of the water pump 171 and the water pump 131 may be driven.

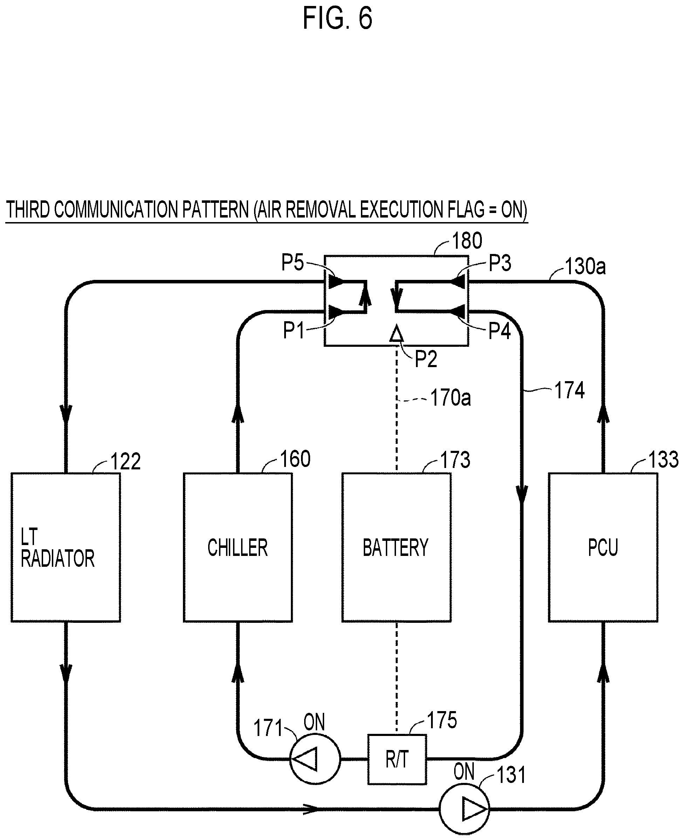

FIG. 6 is a diagram showing an example of a third communication pattern by the five-way valve 180. As shown in FIG. 6, in the third communication pattern, in the five-way valve 180, a path in which the port P1 and the port P5 communicate with each other, and a path in which the port P3 and the port P4 communicate with each other are formed. In this case, the reserve tank 175, the water pump 171, and the water pump 131 are connected in series, and no heat exchange is performed between the heat medium and the battery 173. The third communication pattern is a circuit pattern formed when the "air removal execution flag", which will be described later, is in the ON state and a predetermined condition, which will be described later, is satisfied. In this case, each of the water pump 171 and the water pump 131 is driven. Note that solely one of the water pump 171 and the water pump 131 may be driven.

The first to third communication patterns by the five-way valve 180 are not limited to the examples shown in FIGS. 4 to 6.

Here, as described above, there are cases where a circuit (for example, the first communication pattern) in which the flow path 130a to which the PCU 133 is connected and the reserve tank 175 are not connected is temporarily formed. In this case, in a thermal management system in the related art, there is a concern that air bubbles are mixed (remain) in the flow path 130a.

Therefore, in the present embodiment, in a case where the temperature of the battery 173 is lower than a specified temperature T1 (for example, 35°C) in a state where the flow path 130a and the flow path 170a are disconnected, the thermal management system 1 executes (starts) the air removal process (hereinafter, referred to as "air removal process A") for the flow path 130a and the flow path 170a by connecting the flow path 130a to the flow path 170a via the five-way valve 180 and driving the water pumps 131, 171. That is, the air removal process A means a process of removing air from the flow path 130a and the flow path 170a in a state where the temperature of the battery 173 is lower than the specified temperature T1. The ECU 500 executes the air removal process A by controlling the five-way valve 180 to form the second communication pattern (see FIG. 5) or the third communication pattern (see FIG. 6) and driving the water pumps 131, 171. As a result, air removal is performed on both the flow path 130a and the flow path 170a by the reserve tank 175. The air removal process A and the specified temperature T1 are examples of an "air removal process" and a "first temperature" of the present disclosure, respectively.

### Control Flow of ECU

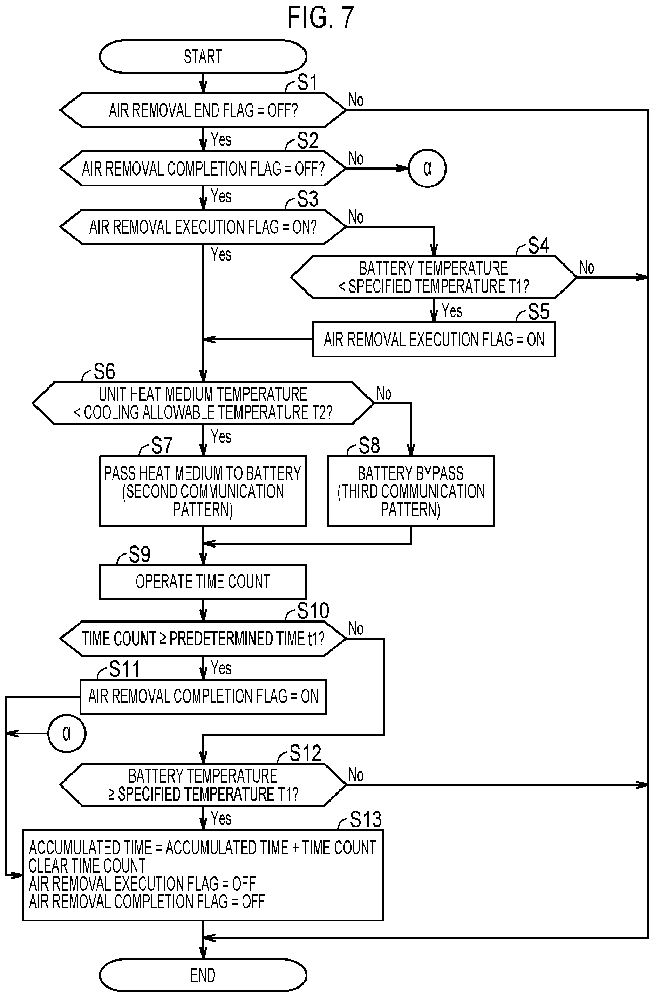

Next, a control flow of the ECU 500 (processor 501) will be described with reference to FIGS. 7 to 10. The control flow shown in FIG. 7 may be executed (started) at a predetermined cycle (for example, every second).

As shown in FIG. 7, in step S1, the ECU 500 determines whether or not an air removal end flag is OFF. The air removal end flag, which will be described in detail later, is a flag (signal) that changes based on a length of an accumulated time during which the air removal is performed on the electrified vehicle 10. In a case where the accumulated time is equal to or shorter than a specified time t2, which will be described later, insufficient air removal is determined, and the air removal end flag is maintained OFF. In a case where the air removal end flag is OFF (Yes in S1), the process proceeds to step S2. In a case where the air removal end flag is ON (No in S1), the process ends.

In step S2, the ECU 500 determines whether or not an air removal completion flag is OFF. The air removal completion flag is a flag indicating whether or not one air removal process A during charging is completed (accomplished). When an execution time (duration) of one air removal process A is shorter than a predetermined time t1, which will be described later, the ECU 500 determines that the air removal process A is not completed, and the air removal completion flag is maintained OFF. In a case where the air removal completion flag is OFF (Yes in S2), the process proceeds to step S3. In a case where the air removal completion flag is ON (No in S2), the process proceeds to step S13.

In step S3, the ECU 500 determines whether or not the air removal execution flag is ON. When the air removal execution flag is ON, the air removal process A is executed. When the air removal execution flag is ON (Yes in S3), the process proceeds to step S6. When the air removal execution flag is OFF (No in S3), the process proceeds to step S4. When the air removal execution flag is OFF, for example, the first communication pattern (see FIG. 4) is formed in the thermal management circuit 100.

In step S4, the ECU 500 determines whether or not the temperature of the battery 173 is lower than the specified temperature T1. Specifically, the ECU 500 determines whether or not a detected value of the temperature sensor 176 (see FIG. 2) is lower than the specified temperature T1 stored in the memory 502 in advance. In a case where the temperature of the battery 173 is lower than the specified temperature T1 (Yes in S4), the ECU 500 determines that the battery 173 does not need to be cooled, and the process proceeds to step S5. In a case where the temperature of the battery 173 is equal to or higher than the specified temperature T1 (No in S4), the cooling of the battery 173 is prioritized, and the process ends.

In step S5, the ECU 500 sets the air removal execution flag to ON. As a result, the ECU 500 starts the air removal process A. Specifically, the ECU 500 forms the second communication pattern (see FIG. 5) or the third communication pattern (see FIG. 6) by controlling the five-way valve 180 and drives the water pumps 131, 171. At the time of step S5, the second communication pattern may be formed or the third communication pattern may be formed. Furthermore, the control of the communication pattern by the five-way valve 180 may be temporarily waited for until the determination in step S6 described later is completed.

In step S6, the ECU 500 determines whether or not the temperature of the heat medium flowing through the low temperature circuit 130 (flow path 130a) is lower than the cooling allowable temperature T2. Specifically, the ECU 500 determines whether or not the detected value of the temperature sensor 136 (see FIG. 2) is smaller than the cooling allowable temperature T2 (for example, 40°C) stored in the memory 502 in advance. When the temperature of the heat medium is lower than the cooling allowable temperature T2 (Yes in S6), the process proceeds to step S7. When the temperature of the heat medium is equal to or higher than the cooling allowable temperature T2 (No in S6), the process proceeds to step S8. The cooling allowable temperature T2 is an example of the "second temperature" in the present disclosure.

In step S7, the ECU 500 controls the five-way valve 180 such that the second communication pattern (see FIG. 5) is formed to allow the heat medium to flow (circulate) through the battery 173 (part 170b). Next, the process proceeds to step S9.

In step S8, the ECU 500 controls the five-way valve 180 such that the third communication pattern (see FIG. 6) is formed to allow the heat medium to flow (circulate) through the bypass path 174 without allowing the heat medium to flow (circulate) through the battery 173 (portion 170b). Next, the process proceeds to step S9.

In step S9, the ECU 500 operates the time count by the timer 505 (see FIG. 2). When the time count by the timer 505 is already operated at the time of step S9, the ECU 500 continues the time count by the timer 505. Next, the process proceeds to step S10.

In step S10, the ECU 500 determines whether or not a time count by the timer 505 is equal to or longer than the predetermined time t1 (for example, 30 seconds to 1 minute). Information on the predetermined time t1 may be stored in the memory 502 in advance. In a case where the time count is equal to or longer than the predetermined time t1 (Yes in S10), the process proceeds to step S11. When the time count is shorter than the predetermined time t1 (No in S10), the process proceeds to step S12. The predetermined time t1 is an example of a "first time" of the present disclosure.

In step S11, the ECU 500 sets the air removal completion flag to ON. Next, the process proceeds to step S13.

In step S12, the ECU 500 determines whether or not the temperature of the battery 173 is equal to or higher than the specified temperature T1. In a case where the temperature of the battery 173 is equal to or higher than the specified temperature T1 (Yes in S12), the process proceeds to step S13. In a case where the temperature of the battery 173 is lower than the specified temperature T1 (No in S12), the process ends.

In step S13, the ECU 500 stores a total value of a current accumulated time and the time count of the timer 505 in the memory 502 and the like as an updated accumulated time. The accumulated time is an accumulated value of a time during which the water pumps 131, 171 are driven in a state where the flow path 170a and the flow path 130a are connected to each other.

That is, the accumulated time is a total value of a first accumulated time during which the air removal process A is executed and a second accumulated time during which the water pumps 131, 171 are driven in a state where the flow path 170a and the flow path 130a are connected to each other at a time other than when the air removal process A is being executed. The first accumulated time is an accumulated value of the time count of the timer 505. The second accumulated time will be described below. The time other than when the air removal process A is being executed refers to a state where the water pumps 131, 171 are driven in a state where the temperature of the battery 173 is equal to or higher than the specified temperature T1 and the flow path 170a and the flow path 130a are connected to each other. Examples of the time other than when the air removal process A is being executed include a case where the temperature of the battery 173 is increased to the specified temperature T1 or higher due to traveling of the electrified vehicle 10, charging, use of an air conditioner, an audio, or the like using an external power, while the water pumps 131, 171 are driven in a state where the flow path 170a and the flow path 130a are connected to each other.

In step S13, the ECU 500 clears the time count of the timer 505. The ECU 500 sets each of the air removal execution flag and the air removal completion flag to OFF. As a result, the air removal process A is stopped (ended). Thereafter, the process ends.

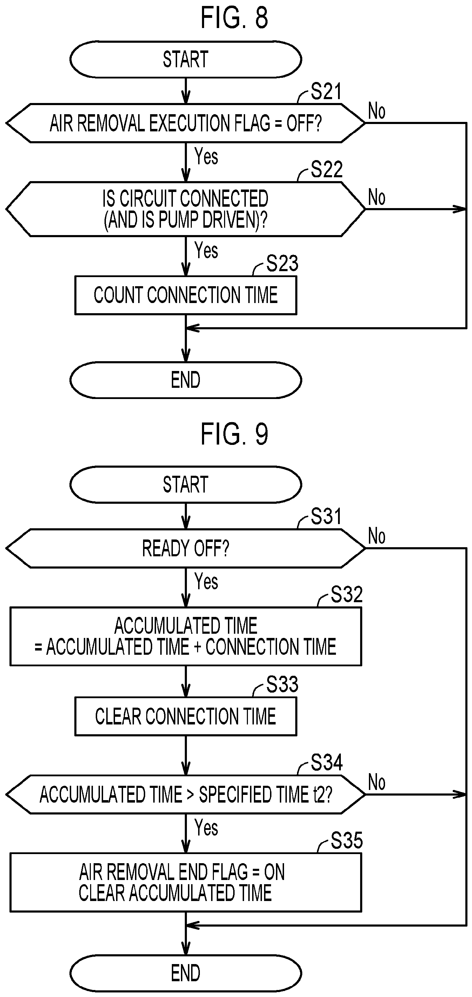

FIG. 8 is a second diagram showing the control flow by the ECU 500 (processor 501) according to the present embodiment. The control flow shown in FIG. 8 may be executed (started) at a predetermined cycle (for example, every second).

In step S21, the ECU 500 determines whether or not the air removal execution flag is OFF. That is, the ECU 500 determines whether or not the air removal process A is being executed. In a case where the air removal execution flag is OFF (Yes in S21), the process proceeds to step S22. In a case where the air removal execution flag is ON (No in S21), the process ends.

In step S22, the ECU 500 determines whether or not the flow path 170a and the flow path 130a are connected to each other and the water pump 131 or 171 is being driven. That is, the ECU 500 determines whether or not the air removal is being executed in each of the flow path 170a and the flow path 130a while the air removal process A is not executed. In a case of Yes in step S22, the process proceeds to step S23. In a case of No in step S22, the process ends.

In step S23, the ECU 500 operates the time count by the timer 506 (see FIG. 2) to count a time (hereinafter, referred to as a connection time) during which the flow path 170a and the flow path 130a are connected to each other and the water pump 131 or 171 is driven. The counted connection time is stored in the memory 502 or the like. Thereafter, the process ends. The connection time is an example of the second accumulated time described above.

FIG. 9 is a third view showing the control flow by the ECU 500 according to the present embodiment. The control flow shown in FIG. 9 may be executed (started) at a predetermined cycle (for example, every second).

In step S31, the ECU 500 determines whether or not the electrified vehicle 10 is in a ready OFF state (unavailable for traveling). Specifically, the ECU 500 determines whether or not the electrified vehicle 10 is in the ready OFF state and an ignition power is in an ON (IGON) (system start) state. In a case where the electrified vehicle 10 is in the ready OFF state (Yes in S31), the process proceeds to step S32. In a case where the electrified vehicle 10 is in a ready ON state (No in S31), the process ends.

In step S32, the ECU 500 stores a total value of the current accumulated time and the connection time (see S23 in FIG. 8) as an updated accumulated time in the memory 502 and the like.

In step S33, the ECU 500 clears information on the connection time. Specifically, the ECU 500 erases the information on the connection time from the memory 502 or the like.

In step S34, the ECU 500 determines whether or not the accumulated time calculated in step S32 exceeds the specified time t2 (for example, 80 hours). That is, the ECU 500 determines whether or not the accumulated time during which the water pump 131 or 171 is driven in a state where the flow path 130a and the flow path 170a are connected to each other exceeds the specified time t2. In a case where the accumulated time exceeds the specified time t2 (Yes in S34), the process proceeds to step S35. In a case where the accumulated time is equal to or shorter than the specified time t2 (No in S34), the process ends. The specified time t2 is an example of a "second time" of the present disclosure.

In step S35, the ECU 500 sets the air removal end flag to ON. That is, as can be seen with reference to step S1 of FIG. 7, after the air removal end flag is set to ON, the air removal process A is not executed (execution is restricted) in the thermal management system 1. Furthermore, the ECU 500 clears information on the accumulated time calculated in step S32. Specifically, the ECU 500 erases the information on the accumulated time from the memory 502 or the like.

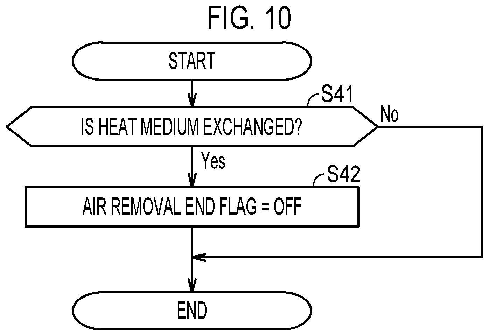

FIG. 10 is a fourth view showing the control flow by the ECU 500 according to the present embodiment. The control flow shown in FIG. 10 may be executed (started) at a predetermined cycle (for example, every second).

In step S41, the ECU 500 determines whether or not the heat medium flowing in the electrified vehicle 10 (thermal management circuit 100) is exchanged. For example, the ECU 500 may determine whether or not the heat medium is exchanged based on information (information indicating that the exchange of the heat medium is completed) input to the electrified vehicle 10 when the heat medium is exchanged at a dealer or the like. In a case where the heat medium is exchanged (Yes in S41), the process proceeds to step S42. In a case where the heat medium is not exchanged (No in S41), the process ends.

In step S42, the ECU 500 sets the air removal end flag to OFF. As a result, as can be seen with reference to step S1 of FIG. 7, after the air removal end flag is set to OFF, the thermal management system 1 is set to a state where the execution of the air removal process A is possible. Thereafter, the process ends.

As described above, in the present embodiment, in a case where the temperature of the battery 173 is lower than the specified temperature T1 in a state where the flow path 130a and the flow path 170a are disconnected, the thermal management system 1 executes the air removal process A for the flow path 130a and the flow path 170a by connecting the flow path 130a to the flow path 170a via the five-way valve 180 and driving the water pumps 131, 171. As a result, it is possible to suppress air bubbles from being mixed (remaining) in each of the flow path 130a and the flow path 170a. As a result, the battery 173, the PCU 133, and the like can be efficiently cooled. Furthermore, by suppressing the water pumps 131, 171 from being driven in a state where the air bubbles are mixed (remain), a load on the water pumps 131, 171 can be reduced. In addition, by performing the air removal in a case where the temperature of the battery 173 is lower than the specified temperature T1, the air bubbles can be removed by the air removal when the battery 173 is at a relatively low temperature. As a result, the air removal can be performed at a time when the air bubbles are less likely to be generated due to heat generation of the battery 173. As a result, the air removal process A can be efficiently executed.

### Modification Example of Thermal Management System

In the embodiment described above, an example has been described in which the communication pattern of the thermal management circuit 100 is controlled by the five-way valve 180, but the present disclosure is not limited thereto. A switching valve other than the five-way valve 180 may be used.

### First Modification Example

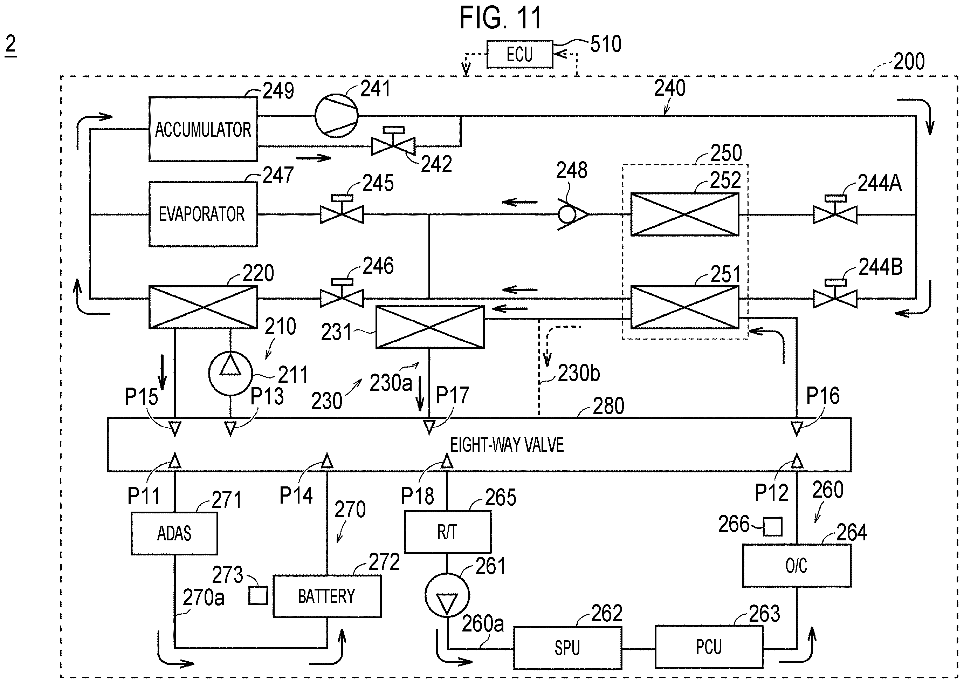

FIG. 11 is a diagram showing an example of an overall configuration of a thermal management system 2 (thermal management circuit 200) that is a first modification example of the embodiment.

The thermal management system 2 includes the thermal management circuit 200. The thermal management circuit 200 includes, for example, a chiller circuit 210, a chiller 220, a radiator circuit 230, a refrigeration cycle 240, a condenser 250, a drive unit circuit 260, a battery circuit 270, and an eight-way valve 280. The thermal management circuit 200 is controlled by an ECU 510. The eight-way valve 280 is an example of a "switching device" of the present disclosure.

The chiller circuit 210 includes a water pump (W/P) 211. The chiller 220 is connected to (shared with) both the chiller circuit 210 and the refrigeration cycle 240.

The radiator circuit 230 includes a radiator 231. The refrigeration cycle 240 includes, for example, a compressor 241, an electromagnetic valve 242, electromagnetic valves 244A, 244B, 245, 246, an evaporator 247, a check valve 248, and an accumulator 249. The condenser 250 includes a water-cooled condenser 251 and an air-cooled condenser 252. The water-cooled condenser 251 is connected to both the refrigeration cycle 240 and the radiator circuit 230.

The drive unit circuit 260 includes, for example, a water pump 261, an SPU 262, a PCU 263, an oil cooler 264, a reserve tank 265, and a heat medium temperature sensor 266. The transaxle may be provided in the drive unit circuit 260 instead of the oil cooler 264. In addition, the PCU 263 and the oil cooler 264 (or the transaxle) may be installed together as an e-axle. The PCU 263 and the oil cooler 264 are devices that can generate a drive force to be supplied to the electrified vehicle. The PCU 263 and the oil cooler 264 are examples of the "first drive device" in the present disclosure. In addition, the water pump 261 is an example of the "pump" of the present disclosure.

The battery circuit 270 includes, for example, an advanced driver-assistance system (ADAS) 271, a battery 272, and a temperature sensor 273. The battery 272 is an example of the "first power storage device" of the present disclosure.

The eight-way valve 280 includes eight ports P11 to P18. The eight-way valve 280 is connected to the chiller circuit 210, the radiator circuit 230, the drive unit circuit 260, and the battery circuit 270.

The heat medium circulating in the chiller circuit 210 flows through a path of the eight-way valve 280 (port P13) - the water pump 211 - the chiller 220 - the eight-way valve 280 (port P15).

The water pump 211 circulates the heat medium in the chiller circuit 210 according to a control command from the ECU 510. The chiller 220 exchanges heat between the heat medium circulating in the chiller circuit 210 and the heat medium circulating in the refrigeration cycle 240. The eight-way valve 280 switches the path to which the chiller circuit 210 is connected according to the control command from the ECU 510. The switching of the path by the eight-way valve 280 will be described in detail later.

The heat medium circulating in the radiator circuit 230 flows through a first path of the eight-way valve 280 (port P16) - the water-cooled condenser 251 - the radiator 231 - the eight-way valve 280 (port P17) or a second path of the eight-way valve 280 (port P16) - the water-cooled condenser 251 - a bypass path 230b - the eight-way valve 280 (port P17). By rotating the eight-way valve 280, the first path and the second path can be switched. The radiator 231 is disposed downstream of a grill shutter (not shown) and exchanges heat between air outside the vehicle and the heat medium.

The heat medium (vapor-phase refrigerant or liquid-phase refrigerant) circulating in the refrigeration cycle 240 flows through any one of the following first to fourth paths. The first path is a path of the compressor 241 - the electromagnetic valve 244A - the air-cooled condenser 252 - the check valve 248 - the electromagnetic valve (expansion valve) 245 - the evaporator 247 - the accumulator 249 - the compressor 241. The second path is a path of the compressor 241 - the electromagnetic valve 244A - the air-cooled condenser 252 - the check valve 248 - the electromagnetic valve (expansion valve) 246 - the chiller 220 - the accumulator 249 - the compressor 241. The third path is a path of the compressor 241 - the electromagnetic valve 244B - the water-cooled condenser 251 - the electromagnetic valve (expansion valve) 245 - the evaporator 247 - the accumulator 249 - and the compressor 241. The fourth path is a path of the compressor 241 - the electromagnetic valve 244B - the water-cooled condenser 251 - the electromagnetic valve 246 - the chiller 220 - the accumulator 249 - the compressor 241.

The compressor 241 compresses the vapor-phase refrigerant circulating in the refrigeration cycle 240 according to the control command from the ECU 510. The electromagnetic valve 242 is connected in parallel to the compressor 241, and adjusts an amount of the vapor-phase refrigerant flowing into the compressor 241 according to the control command from the ECU 510. The electromagnetic valve 244 (244A, 244B) switches whether the vapor-phase refrigerant discharged from the compressor 241 flows into the water-cooled condenser 251 or the air-cooled condenser 252, according to the control command from the ECU 510. The water-cooled condenser 251 exchanges heat between the vapor-phase refrigerant discharged from the compressor 241 and the heat medium flowing through the radiator circuit 230. The air-cooled condenser 252 exchanges heat with air introduced into a vehicle cabin to produce warm air. The electromagnetic valve 245 restricts an inflow of the liquid-phase refrigerant to the evaporator 247 according to the control command from the ECU 510. The electromagnetic valve 246 restricts the inflow of the liquid-phase refrigerant to the chiller 220 according to the control command from the ECU 510. The electromagnetic valves 245, 246 also have a function of expanding the liquid-phase refrigerant. The accumulator 249 removes the liquid-phase refrigerant from the refrigerant in a gas-liquid mixed state, and prevents the liquid-phase refrigerant from being suctioned into the compressor 241 in a case where the refrigerant is not completely vaporized by the evaporator 247.

The heat medium (coolant) circulating in the drive unit circuit 260 flows through a path of the eight-way valve 280 (port P18) - the reserve tank 265 - the water pump 261 - the SPU 262 - the PCU 263 - the oil cooler 264 - the eight-way valve 280 (port P12).

The water pump 261 circulates the heat medium in the drive unit circuit 260 according to the control command from the ECU 510. The SPU 262 controls charging and discharging of the battery 272 according to the control command from the ECU 510. The PCU 263 converts direct current power supplied from the battery 272 into alternating current power according to the control command from the ECU 510, and supplies the alternating current power to a motor (not shown) built in the transaxle. The oil cooler 264 cools the transaxle by exchanging heat between the heat medium circulating in the drive unit circuit 260 and the lubricating oil of the motor. Alternatively, heat generated by supplying electric power to a stator without rotating a rotor of the motor may be exchanged with the heat medium circulating in the drive unit circuit 260.

The SPU 262, the PCU 263, and the oil cooler 264 are cooled by the heat medium circulating in the drive unit circuit 260. The reserve tank 265 stores a portion of the heat medium (the heat medium that overflows due to an increase in pressure) in the drive unit circuit 260, and maintains the pressure and amount of the heat medium in the drive unit circuit 260.

The heat medium temperature sensor 266 detects the temperature of the heat medium in a flow path 260a, which will be described later, in which the PCU 263 and the like are provided. Specifically, the heat medium temperature sensor 266 detects the temperature of the heat medium flowing between the oil cooler 264 and the eight-way valve 280 (downstream of the oil cooler 264). The heat medium temperature sensor 266 may detect, for example, the temperature of the heat medium between the PCU 263 and the oil cooler 264.

The heat medium (coolant) circulating in the battery circuit 270 flows through a path of the eight-way valve 280 (port P11) - the ADAS 271 - the battery 272 - the eight-way valve 280 (port P14).

The ADAS 271 includes, for example, adaptive cruise control (ACC), an automatic speed limiter (ASL), lane keeping assist (LKA), a pre-crash safety (PCS), and a lane departure alert (LDA). The battery circuit 270 may include an autonomous driving system (ADS) in addition to the ADAS 271. The battery 272 supplies electric power for traveling to the motor built in the transaxle. The temperature sensor 273 detects a temperature of the battery 272.

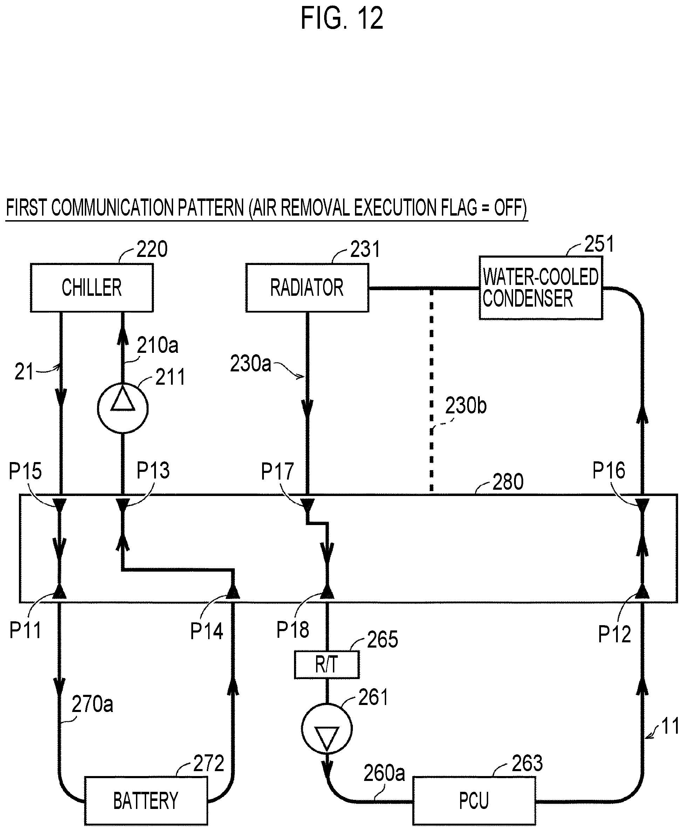

As shown in FIG. 12, the chiller 220 is provided in a flow path 210a of the chiller circuit 210. The flow path 210a is a flow path that connects the port P13 and the port P15 of the eight-way valve 280.

The radiator 231 is provided in a flow path 230a of the radiator circuit 230. The flow path 230a includes the bypass path 230b that bypasses the radiator 231. The bypass path 230b is provided to connect a portion between the water-cooled condenser 251 and the radiator 231 to the eight-way valve 280. In a case where the heat medium flows through the bypass path 230b, the heat medium does not flow through the radiator 231. In a case where the heat medium flows through the radiator 231, the heat medium does not flow through the bypass path 230b.

The water pump 261, the SPU 262, the PCU 263, the oil cooler 264, and the reserve tank 265 (the illustration of the SPU 262 and the oil cooler 264 is omitted in FIG. 12) are provided in the flow path 260a of the drive unit circuit 260. The flow path 260a is a flow path that connects the port P18 and the port P12 of the eight-way valve 280. The flow path 260a is an example of the "second flow path" of the present disclosure.

The battery 272 is provided in a flow path 270a of the battery circuit 270. The flow path 270a is a flow path that connects the port P11 and the port P14 of the eight-way valve 280. The flow path 270a is an example of the "first flow path" of the present disclosure.

### Communication Pattern

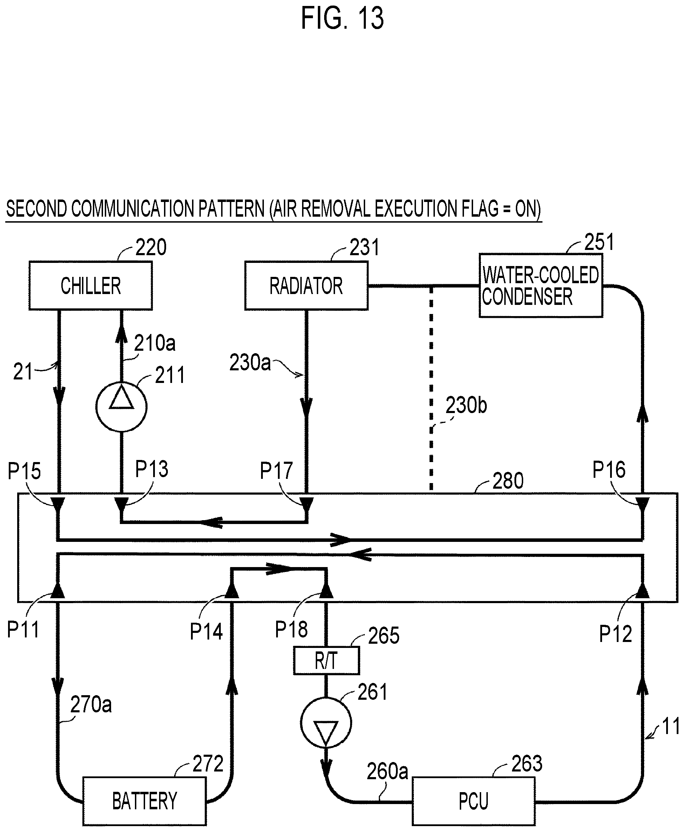

FIGS. 12 and 13 are diagrams showing examples of a first communication pattern and a second communication pattern by the eight-way valve 280, respectively. The first communication pattern and the second communication pattern by the eight-way valve 280 are not limited to the examples shown in FIGS. 12 and 13, respectively.

As shown in FIG. 12, in the first communication pattern, a path in which the port P11 and the port P15 communicate with each other in the eight-way valve 280 is formed. Additionally, in the first communication pattern, a path in which the port P14 with and the port P13 communicate with each other in the eight-way valve 280 is formed. Additionally, in the first communication pattern, a path in which the port P17 and the port P18 communicate with each other in the eight-way valve 280 is formed. Additionally, in the first communication pattern, a path in which the port P12 and the port P16 communicate with each other in the eight-way valve 280 is formed. Additionally, in the first communication pattern, the radiator 231 and the port P17 of the eight-way valve 280 are connected by the flow path 230a. As described above, in the first communication pattern, the flow path 270a and the flow path 260a are disconnected. The first communication pattern shown in FIG. 12 is a circuit pattern corresponding to the first communication pattern of the first embodiment (see FIG. 4).

As shown in FIG. 13, in the second communication pattern, a path in which the port P11 and the port P12 communicate with each other in the eight-way valve 280 is formed. In the second communication pattern, a path in which the port P14 and the port P18 communicate with each other in the eight-way valve 280 is formed. In the second communication pattern, a path in which the port P13 and the port P17 communicate with each other in the eight-way valve 280 is formed. In the second communication pattern, a path in which the port P15 and the port P16 communicate with each other in the eight-way valve 280 is formed. In the second communication pattern, the radiator 231 and the port P17 of the eight-way valve 280 are connected by the flow path 230a. As described above, in the second communication pattern, the flow path 270a and the flow path 260a are connected to each other. That is, the second communication pattern shown in FIG. 13 is a circuit pattern corresponding to the second communication pattern of the second embodiment (see FIG. 5).

As in the thermal management system 1 of the first embodiment, in a case where the temperature of the battery 272 is lower than the specified temperature T1 (for example, 35°C) in a state where the flow path 270a and the flow path 260a are disconnected (see FIG. 12), the thermal management system 2 executes the air removal process A for the flow path 270a and the flow path 260a by connecting the flow path 270a to the flow path 260a via the eight-way valve 280 and driving the water pump 261. The control flow of the embodiment described above may be applied to a control flow of the air removal process in the first modification example.

### Modification Example of First Modification Example

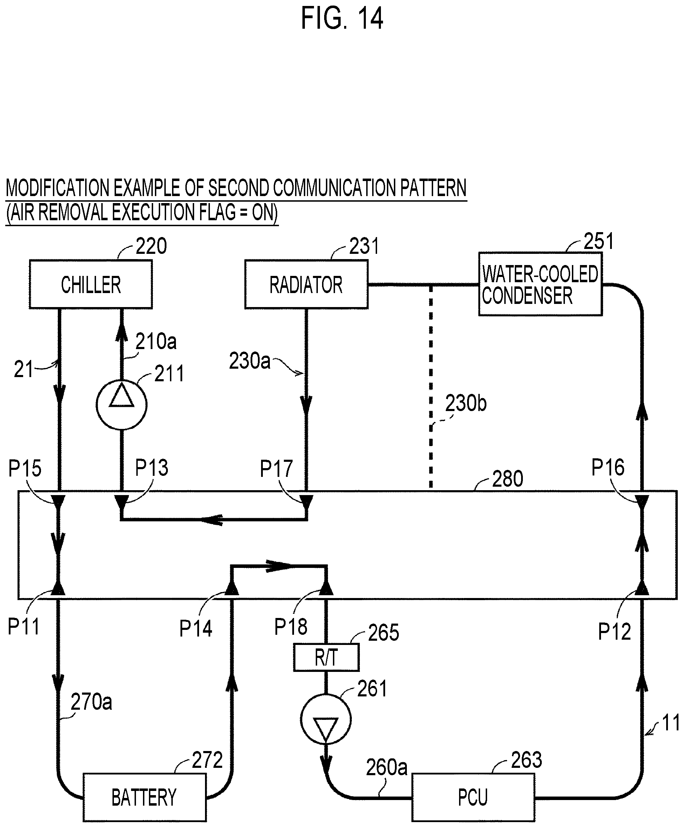

In the first modification example, an example has been described in which the flow path 270a and the flow path 260a are connected to each other in the second communication pattern, but the present disclosure is not limited thereto. As shown in FIG. 14, as the second communication pattern, the flow path 270a, the flow path 260a, the flow path 230a (or the bypass path 230b), and the flow path 210a may be connected.

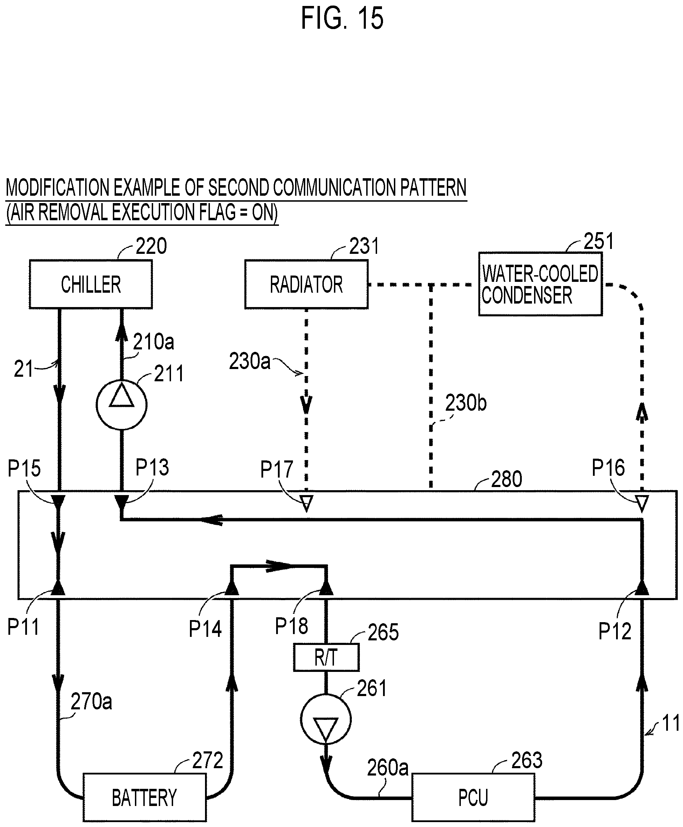

Alternatively, as shown in FIG. 15, as the second communication pattern, the flow path 270a, the flow path 260a, and the flow path 210a may be connected. In this case, the flow path 230a (and the bypass path 230b) is disconnected from the other flow paths. Although not shown, as the second communication pattern, the flow path 270a, the flow path 260a, and the flow path 230a (or the bypass path 230b) may be connected, and the flow path 210a may be disconnected from the other flow paths.

A combination of the first communication pattern and the second communication pattern is not limited to the examples described above. For example, the circuit shown in FIG. 13 or 15 may be the first communication pattern, and the circuit shown in FIG. 14 may be the second communication pattern. Alternatively, the circuit shown in FIG. 13 may be the first communication pattern, and the circuit shown in FIG. 14 or 15 may be the second communication pattern.

### Second Modification Example

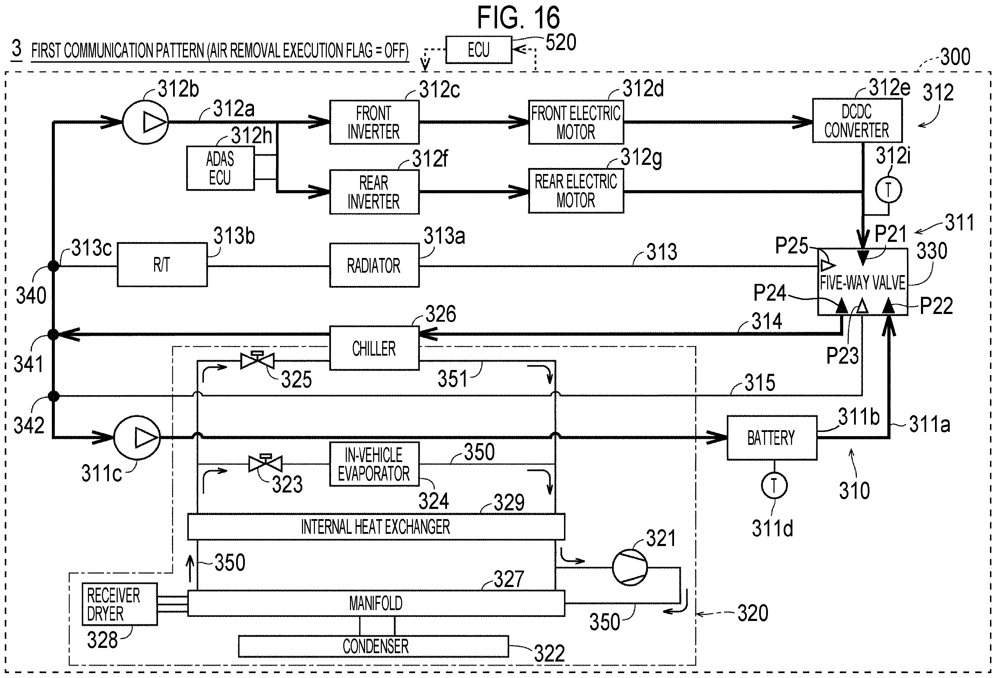

FIG. 16 is a diagram showing an example of an overall configuration of a thermal management system 3 (thermal management circuit 300) that is a second modification example of the embodiment.

The thermal management circuit 300 includes a heat medium circuit 310 including a heat medium (water or the like), and a refrigeration circuit 320 including a working medium (water or a medium having a lower boiling point than water). Hereinafter, the refrigeration circuit 320 will be described first.

The refrigeration circuit 320 includes a compressor 321, a condenser 322, a first expansion valve 323, an in-vehicle evaporator 324, a second expansion valve 325, a chiller 326, a circulation flow path 350, and an in-vehicle evaporator bypass flow path 351.

The compressor 321 compresses the working medium. The condenser 322 condenses the working medium discharged from the compressor 321. The first expansion valve 323 expands the working medium flowing out of the condenser 322. The in-vehicle evaporator 324 exchanges heat between the working medium flowing out of the first expansion valve 323 and the air in the vehicle (in the vehicle cabin).

The circulation flow path 350 is a flow path in which the working medium circulates. The circulation flow path 350 connects the compressor 321, the condenser 322, the first expansion valve 323, and the in-vehicle evaporator 324 in this order.

The in-vehicle evaporator bypass flow path 351 is connected to the circulation flow path 350 to bypass the in-vehicle evaporator 324. The second expansion valve 325 is provided in the in-vehicle evaporator bypass flow path 351.

The refrigeration circuit 320 further includes a manifold 327, a receiver dryer 328, and an internal heat exchanger 329.

The manifold 327 is provided in the circulation flow path 350. The receiver dryer 328 is connected to the manifold 327. The internal heat exchanger 329 is connected to a portion of the circulation flow path 350 upstream of the first expansion valve 323 and a portion of the circulation flow path 350 downstream of the in-vehicle evaporator 324.

Next, the heat medium circuit 310 will be described. The heat medium circuit 310 includes a first circuit 311, a second circuit 312, a flow path 313, a radiator 313a, a reserve tank 313b, a flow path 314, a chiller 326, a flow path 315, and a five-way valve 330. The five-way valve 330 includes ports P21 to P25. The five-way valve 330 is an example of the "switching device" of the present disclosure.

The first circuit 311 includes a flow path 311a, a battery 311b, a water pump 311c, and a temperature sensor 311d. The first circuit 311 is a circuit formed by the flow path 311a and any one of the flow paths 313 to 315. The water pump 311c and the flow path 311a are examples of the "pump" and the "first flow path" of the present disclosure, respectively. The battery 311b is an example of the "second power storage device" and the "heat-exchanged device" of the present disclosure.

The flow path 311a is a flow path through which the heat medium flows. The flow path 311a is a flow path that connects the water pump 311c and the port P22 of the five-way valve 330. The battery 311b is connected to the flow path 311a such that the battery 311b exchanges heat with the heat medium flowing through the flow path 311a. That is, the battery 311b is thermally in contact with the flow path 311a. The water pump 311c is provided in the flow path 311a. The temperature sensor 311d detects a temperature of the battery 311b.

The second circuit 312 includes a flow path 312a, a water pump 312b, a drive device, and a temperature sensor 312i. The second circuit 312 is a circuit formed by the flow path 312a and any one of the flow paths 313 to 315. The water pump 312b and the flow path 312a are examples of the "pump" and the "first flow path" of the present disclosure, respectively.

The flow path 312a is a flow path through which the heat medium flows. The flow path 312a is a flow path that connects the water pump 312b and the port P21 of the five-way valve 330. The water pump 312b is provided in the flow path 312a.

The drive device is a device that can generate a drive force to be supplied to the electrified vehicle. The drive device is connected to the flow path 312a such that the drive device exchanges heat with the heat medium flowing through the flow path 312a. That is, the drive device is thermally in contact with the flow path 312a. The drive device is connected to a portion of the flow path 312a downstream of the water pump 312b. The drive device includes a front inverter 312c, a front electric motor 312d, a DCDC converter 312e, a rear inverter 312f, and a rear electric motor 312g. An advanced driver-assistance system (ADAS)-electronic control unit (ECU) 312h is connected to the flow path 312a. The drive device described above is an example of a "second drive device" of the present disclosure.

The temperature sensor 312i detects the temperature of the heat medium flowing through the second circuit 312 (flow path 312a). Specifically, the temperature sensor 312i detects the temperature of the heat medium immediately after flowing through the drive device (immediately before flowing into the five-way valve 330).

The flow path 313 is a flow path through which the heat medium flows. The radiator 313a and the reserve tank 313b are provided in the flow path 313. The flow path 313 is an example of the "second flow path" of the present disclosure.

The flow path 314 is a flow path through which the heat medium flows. The chiller 326 is connected to the flow path 314 and the in-vehicle evaporator bypass flow path 351. The chiller 326 exchanges heat between the heat medium flowing through the flow path 314 and the working medium flowing through the in-vehicle evaporator bypass flow path 351.

The five-way valve 330 can switch connection states between the flow path 311a, the flow path 312a, the flow path 313, the flow path 314, and the flow path 315.

As shown in FIG. 16, a first end portion of the flow path 311a is connected to the port P22 of the five-way valve 330. The heat medium flowing through the flow path 311a flows into the five-way valve 330 from the port P22. A second end portion of the flow path 311a is connected to the water pump 311c.

A first end portion of the flow path 312a is connected to the port P21 of the five-way valve 330. The heat medium flowing through the flow path 312a flows into the five-way valve 330 from the port P21. A second end portion of the flow path 312a is connected to the water pump 312b.

A first end portion of the flow path 313 is connected to the port P25 of the five-way valve 330. The heat medium flowing out of the port P25 flows through the flow path 313. A second end portion 313c of the flow path 313 is connected to a branch portion 340.

A first end portion of the flow path 314 is connected to the port P24 of the five-way valve 330. The heat medium flowing out of the port P24 flows through the flow path 314. A second end portion of the flow path 314 is connected to a branch portion 341.

A first end portion of the flow path 315 is connected to the port P23 of the five-way valve 330. The heat medium flowing out of the port P23 flows through the flow path 315. A second end portion of the flow path 315 is connected to a branch portion 342. The branch portion 341 is provided between the branch portion 340 and the branch portion 342.

As described above, the flow path 311a and the flow path 312a are connected to the five-way valve 330 in parallel to each other.

The five-way valve 330 can switch the thermal management circuit 300 between a heating mode in which the battery 311b is heated, a cooling mode in which the battery 311b is cooled, a vehicle cabin cooling mode, a vehicle cabin heating mode, and a combination of the modes. The five-way valve 330 is switched by an ECU 520.

FIG. 16 shows an example of a first communication pattern of the thermal management circuit 300. In the first communication pattern, the ports P21, P22, P24 are opened, and the ports P23, P25 are closed. Each of the water pumps 311c, 312b is driven.

In the first communication pattern, the heat medium flowing out from the port P24 of the five-way valve 330 to the flow path 314 is branched at the branch portion 341 and is directed toward each of the flow path 311a and the flow path 312a. The heat medium pressurized by the water pump 312b exchanges heat with the drive device and then flows into the port P21 of the five-way valve 330. The heat medium pressurized by the water pump 311c exchanges heat with the battery 311b and then flows into the port P22 of the five-way valve 330. In the first communication pattern, the heat medium does not pass through the reserve tank 313b, and thus, air removal is not performed on each of the flow path 311a and the flow path 312a.

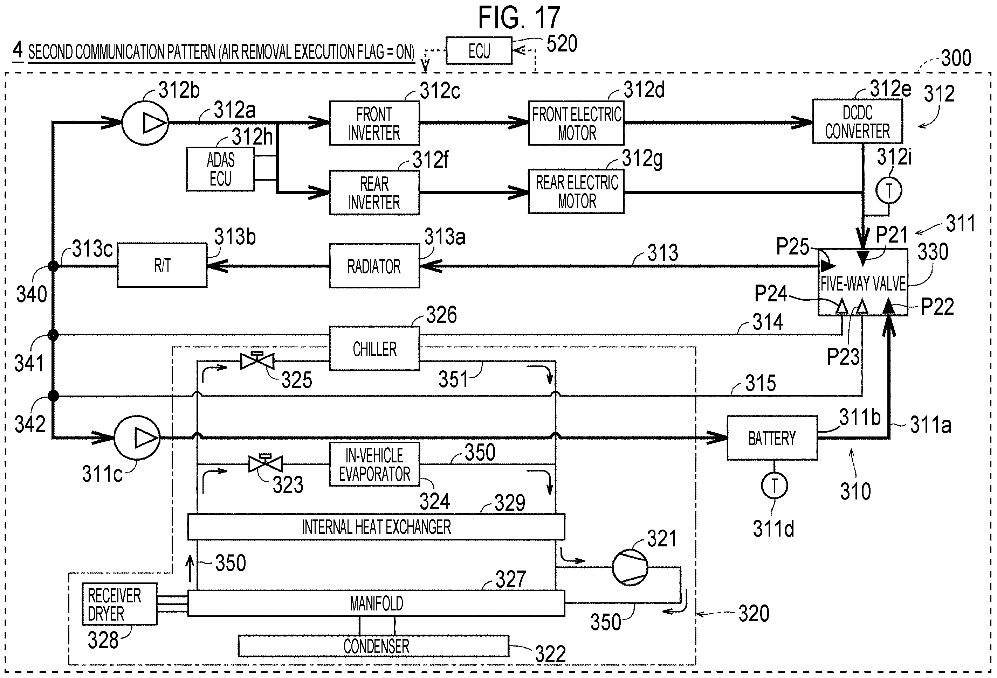

FIG. 17 shows an example of a second communication pattern of the thermal management circuit 300. In the second communication pattern, the ports P21, P22, P25 are opened, and the ports P23, P24 are closed. Each of the water pumps 311c, 312b is driven.

The heat medium flowing out from the port P25 of the five-way valve 330 to the flow path 313 passes through the reserve tank 313b, is branched at the branch portion 340, and is directed toward each of the flow path 311a and the flow path 312a. As a result, air removal is performed on each of the flow path 311a and the flow path 312a by the reserve tank 313b.

As in the first embodiment, in a case where the temperature of the battery 311b is lower than the specified temperature T1 (for example, 35°C) in a state where the flow paths 311a, 312a and the flow path 313 are disconnected (see FIG. 16), the thermal management system 3 executes the air removal process for the flow paths 311a, 312a and the flow path 313 by connecting the flow paths 311a, 312a to the flow path 313 via the five-way valve 330 (see FIG. 17) and driving the water pumps 311c, 312b. The control flow of the embodiment described above may be applied to a control flow of the air removal process in the second modification example.

### Modification Example of Second Modification Example

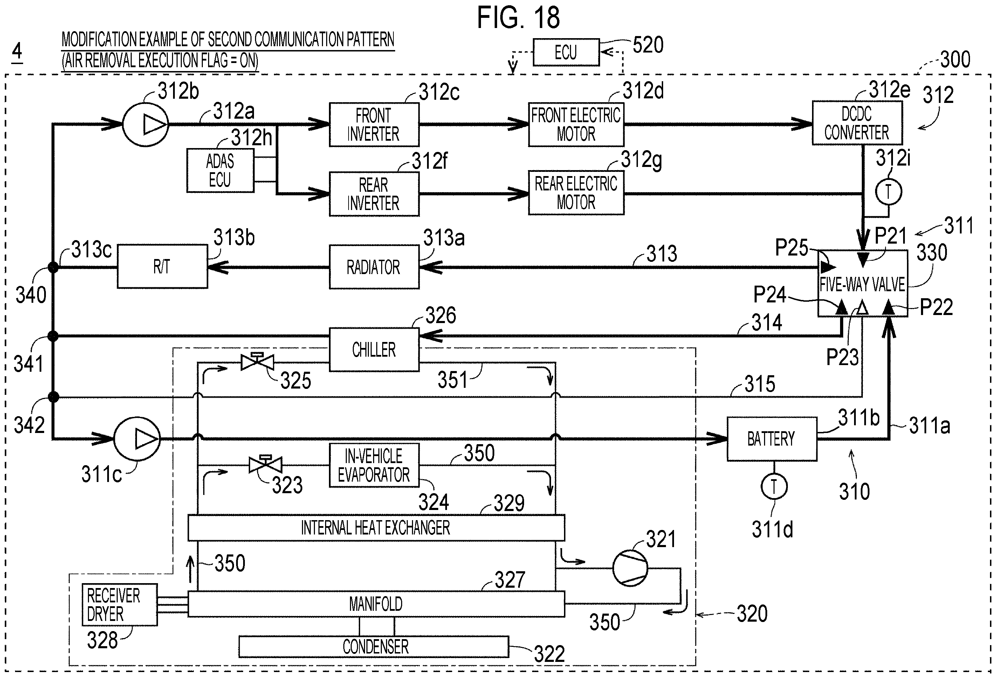

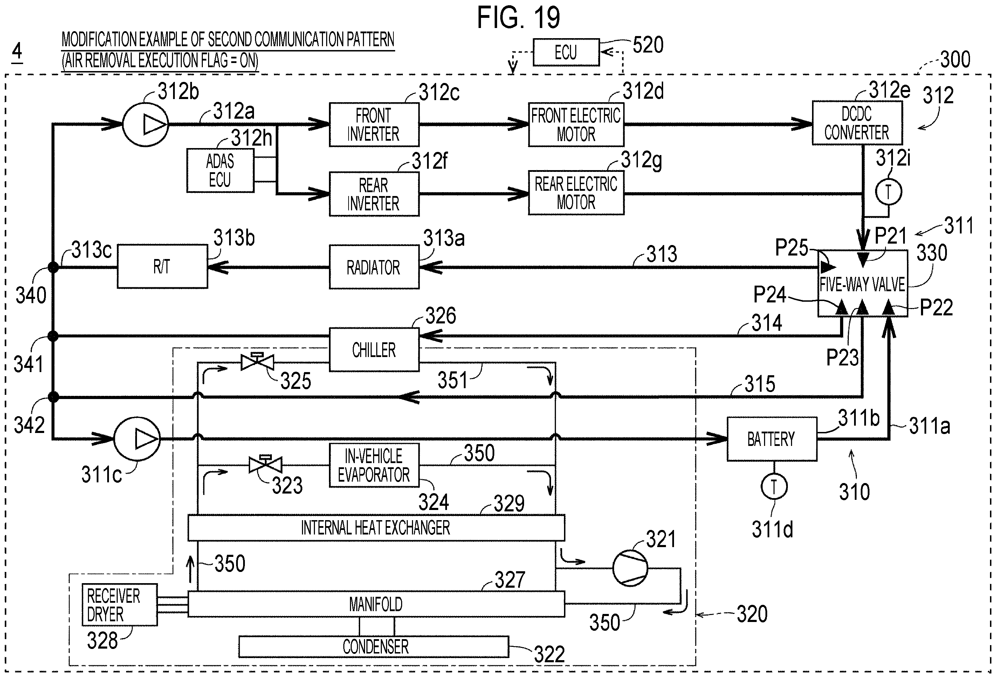

In the second modification example described above, an example has been described in which the flow path 311a, the flow path 312a, and the flow path 313 are connected in the second communication pattern, but the present disclosure is not limited thereto. For example, as shown in FIG. 18, as the second communication pattern, the flow path 311a, the flow path 312a, the flow path 313, and the flow path 314 may be connected. Alternatively, as shown in FIG. 19, as the second communication pattern, the flow path 311a, the flow path 312a, the flow path 313, the flow path 314, and the flow path 315 may be connected.

Although not shown, as the second communication pattern, one or two of the flow path 311a, the flow path 312a, the flow path 314, and the flow path 315 may be connected to the flow path 313.

A combination of the first communication pattern and the second communication pattern is not limited to the examples described above. For example, the circuit shown in FIG. 17 may be the first communication pattern, and the circuit shown in FIG. 18 or 19 may be the second communication pattern. Alternatively, the circuit shown in FIG. 18 may be the first communication pattern, and the circuit shown in FIG. 19 may be the second communication pattern.

Furthermore, even in the thermal management circuit according to the first modification example and the second modification example, the bypass path that bypasses the battery may be provided as in the embodiment.

### Other Modification Examples

In the embodiment, an example has been described in which the thermal management system 1 is mounted on the electrified vehicle 10, but the present disclosure is not limited thereto. The thermal management system may be mounted on an electric device (for example, a stationary power storage device) other than the electrified vehicle.

In the above-described embodiment, an example has been described in which the flow path of the heat medium is switched by the five-way valve 180, but the present disclosure is not limited thereto. For example, the flow path of the heat medium may be switched by a six-way valve or a ten-way valve. Moreover, a plurality of switching valves may be provided.

In the embodiment, an example has been described in which the reserve tank 175 is disposed in the flow path 170a in which the battery 173 is provided, but the present disclosure is not limited thereto. The reserve tank may not be disposed in the flow path 170a, and the reserve tank may be disposed in the flow path 130a in which the drive device (the PCU 133 or the like) is provided.

In the embodiment, an example has been described in which the air removal process A is executed by connecting the flow path 170a in which the battery 173 is provided to the flow path 130a in which the drive device (the PCU 133 or the like) is provided in a case where the temperature of the battery 173 is lower than the specified temperature T1, but the present disclosure is not limited thereto. The air removal process may be executed by connecting flow paths other than the two flow paths in a case where the temperature of the battery 173 is lower than the specified temperature T1.

In the embodiment, an example has been described in which the bypass path 174 that bypasses the battery 173 is provided in the thermal management circuit 100, but the present disclosure is not limited thereto. The bypass path 174 that bypasses the battery 173 may not be provided in the thermal management circuit. In this case, the process of steps S6 to S8 in FIG. 7 may not be executed.

In the embodiment, an example has been described in which the air removal process A is not executed in a case where the accumulated time during which the air removal process is being performed exceeds the specified time t2 (upper limit), but the present disclosure is not limited thereto. The accumulated time during which the air removal is being performed may not have an upper limit.

In the embodiment, an example has been described in which the air removal end flag is set to ON in a case where a total time of the accumulated time (first accumulated time) during which the air removal process A is being executed and the second accumulated time during which the water pumps 131, 171 are driven in a state where the flow path 170a and the flow path 130a are connected to each other at a time other than when the air removal process A is executed, exceeds the specified time t2, but the present disclosure is not limited thereto. For example, in a case where the accumulated time during which the air removal process A is being performed exceeds the specified time t2, the air removal end flag may be set to ON.

In the embodiment, an example has been described in which the water pump is provided in each of the flow path 170a and the flow path 130a, but the present disclosure is not limited thereto. The water pump may be provided solely in one of the flow path 170a and the flow path 130a.

In the embodiment, an example has been described in which the ECU 500 includes two timers and the two timers measure different times, but the present disclosure is not limited thereto. The ECU may be provided with solely one timer.

The configurations (processes) of the embodiment and the modification examples may be combined with each other.

The embodiment disclosed herein is to be considered merely illustrative and not restrictive in all respects. The scope of the present disclosure is indicated by the scope of claims rather than by the description of the above-described embodiment, and is intended to include all modifications within the scope and meaning equivalent to the scope of the claims.

## Claims

1. A thermal management system provided in a chargeable electric device, the thermal management system comprising:
a first flow path (130a) through which a heat medium flows;
a second flow path (170a) through which the heat medium flows and in which a reserve tank is provided;
a heat-exchanged device (173) configured to exchange heat with the heat medium flowing through one of the first flow path and the second flow path;
a switching device (180) configured to switch a connection state between the first flow path and the second flow path;
a pump (131) configured to circulate the heat medium in each of the first flow path and the second flow path in a state where the first flow path and the second flow path are connected; and
a control device (500) configured to control the switching device and the pump,
wherein the control device (500) is configured to, in a case where a temperature of the heat-exchanged device (173) is lower than a first temperature in a state where the first flow path (130a) and the second flow path (170a) are disconnected, connect the first flow path (130a) and the second flow path (170a) by the switching device (180) and to execute an air removal process for the first flow path (130a) and the second flow path (170a) by driving the pump (131).

2. The thermal management system according to claim 1, wherein the control device is configured to end the air removal process in a case where the air removal process has continued for a first time or longer.

3. The thermal management system according to claim 1 or 2, wherein:
the heat-exchanged device (173) includes a first power storage device; and
the thermal management system further comprises a first drive device configured to exchange heat with the heat medium flowing through the other of the first flow path (130a) and the second flow path (170a) and to generate a drive force.

4. The thermal management system according to claim 3, wherein the control device is configured to stop the air removal process in a case where a temperature of the first power storage device is equal to or higher than the first temperature during the execution of the air removal process.

5. The thermal management system according to claim 3, further comprising a bypass path that bypasses at least a portion of the one of the first flow path (130a) and the second flow path (170a) at which heat exchange between the first power storage device and the heat medium occurs,
wherein the control device (500) is configured to, during the execution of the air removal process, cause the heat medium to flow through the bypass path without causing the heat medium to flow through the portion in a case where a temperature of the heat medium flowing through the other of the first flow path (130a) and the second flow path (170a) is equal to or higher than a second temperature.

6. The thermal management system according to claim 1 or 2, wherein the control device does not execute the air removal process in a case where an accumulated time during which the pump (131) is driven in the state where the first flow path (130a) and the second flow path (170a) are connected exceeds a second time.

7. The thermal management system according to claim 6, wherein the accumulated time is a total value of a first accumulated time during which the air removal process is executed and a second accumulated time during which the pump (131) is driven in the state where the first flow path and the second flow path are connected at a time other than when the air removal process is being executed.

8. The thermal management system according to claim 1 or 2, wherein the control device is configured to, in a case where the heat medium flowing through the electric device in a state where the air removal process is not being executed is exchanged, set the thermal management system to a state in which the air removal process is executable.

9. The thermal management system according to claim 1 or 2, wherein the switching device (180) includes a five-way valve or an eight-way valve.

10. The thermal management system according to claim 1 or 2, further comprising:
a radiator; and
a second drive device configured to generate a drive force, wherein:
the heat-exchanged device includes a second power storage device;
the radiator is provided in the second flow path (170a); and
at least one of the second power storage device and the second drive device exchanges heat with the heat medium flowing through the first flow path (130a).
